# EUROPEAN PATENT APPLICATION

(11) **EP 3 032 372 A1**
(43) Date of publication of application: **15.06.2016**
(21) Application number: 15182664.1
(22) Date of filing: 27.08.2015
(51) Int. Cl.: G06F 1/26

(54) **METHOD FOR PERFORMING IMPEDANCE PROFILE CONTROL OF A POWER DELIVERY NETWORK IN AN ELECTRONIC DEVICE, AND ASSOCIATED APPARATUS**

(30) Priority: 12.12.2014 US 201462090892 P; 20.08.2015 US 201514830738
(71) Applicant: MediaTek, Inc, Hsin-Chu 300 (TW)
(72) Inventor: CHEN, Shang-Pin, 302 Hsinchu County (TW); LEE, Sheng-Feng, 300 Hsinchu City (TW)
(74) Representative: Hoefer & Partner Patentanwälte mbB

(57) **Abstract**

A method and apparatus (100, 700, 800) for performing impedance profile control of a power delivery network (PDN) in an electronic device (100, 700, 800) are provided. The method includes the steps of: utilizing a capacitive component (112, 716, 719, 816, 819) and a resistive component (114, 714, 718, 814, 818) that are coupled in series as an output stage (110) of the PDN, wherein the capacitive component includes one terminal (1121) coupled to a first voltage level of the PDN and further includes another terminal (1122), and the resistive component includes a first terminal (1141) coupled to the other terminal (1122) of the capacitive component and further includes a second terminal (1142) coupled to a second voltage level of the PDN; and inputting a control signal into a third terminal (1143) of the resistive component, to control an impedance profile of the output stage of the PDN, wherein in a predetermined state of the control signal, the control signal is a time variant signal. The control signal may be digital or analog.

## Description

The present invention relates to a method and apparatus for performing impedance profile control of a power delivery network (PDN) in an electronic device according to the pre-characterizing clauses of claims 1 and 11.

Decoupling is important for a conventional electronic device, for example, a capacitor can be used to decouple one part of an internal circuit of the conventional electronic device from another, where the noise caused by some circuit elements may be shunted through the capacitor, or may be reduced by the capacitor; however, according to the related art, when preparing a newer model of the conventional electronic device to be launched onto the market, the design regarding the decoupling components of a conventional PDN may need to be changed since some hardware circuits in the conventional electronic device are typically changed. As a result, the circuit arrangement of the conventional PDN may need to be revised, which may cause additional problems. Thus, how to guarantee the performance of a PDN with fewer design efforts has become an important issue to be solved.

This in mind, the present invention aims at providing a method and apparatus for performing impedance profile control of a PDN in an electronic device that guarantee the performance of the PDN with fewer design efforts and improve the overall performance of the electronic device.

This is achieved by a method and apparatus for performing impedance profile control of a PDN in an electronic device according to the pre-characterizing clauses of claims 1 and 11. The dependent claims pertain to corresponding further developments and improvements.

In one aspect, the disclosure features a method for performing impedance profile control of a PDN in an electronic device, where the method comprises the steps of: utilizing a capacitive component and a resistive component that are coupled in series as an output stage of the PDN, wherein the capacitive component comprises one terminal coupled to a first voltage level of the PDN and further comprises another terminal, and the resistive component comprises a first terminal coupled to the other terminal of the capacitive component and further comprises a second terminal coupled to a second voltage level of the PDN; and inputting a control signal into a third terminal of the resistive component, to control an impedance profile of the output stage of the PDN, wherein in at least one predetermined state of the control signal, the control signal is a time variant signal. For example, the control signal may be a digital control signal, wherein in a logical state of the digital control signal, the digital control signal is the time variant signal. In another example, the control signal may be an analog control signal.

In one aspect, the disclosure features an apparatus for performing impedance profile control of a PDN in an electronic device, where the apparatus comprises at least one portion of the electronic device. The apparatus may comprise a capacitive component and a resistive component that are coupled in series, and may further comprise a control module that is coupled to the resistive component. The capacitive component and the resistive component are utilized as an output stage of the PDN, wherein the capacitive component comprises one terminal coupled to a first voltage level of the PDN and further comprises another terminal, and the resistive component comprises a first terminal coupled to the other terminal of the capacitive component and further comprises a second terminal coupled to a second voltage level of the PDN. In addition, the control module is arranged for inputting a control signal into a third terminal of the resistive component, to control an impedance profile of the output stage of the PDN, wherein in at least one predetermined state of the control signal, the control signal is a time variant signal. For example, the control signal may be a digital control signal, wherein in a logical state of the digital control signal, the digital control signal is the time variant signal. In another example, the control signal may be an analog control signal.

It is an advantage of the present invention that the present invention method and the associated apparatus can guarantee the performance of the PDN with fewer design efforts and can improve the overall performance of the electronic device. In addition, the present invention method and the associated apparatus can change at least one characteristic of the digital control signal to adjust the frequency response of the output stage of the PDN in different conditions (e.g. in response to different hardware configurations of the electronic device), respectively, to satisfy various requirements, respectively.

In the following, the invention is further illustrated by way of example, taking reference to the accompanying drawings. Thereof
FIG. 1 is a diagram of an apparatus for performing impedance profile control of a power delivery network (PDN) in an electronic device according to a first embodiment of the present invention,
FIG. 2 illustrates a flowchart of a method for performing impedance profile control of a PDN in an electronic device according to an embodiment of the present invention,
FIG. 3 illustrates a control scheme involved with the method shown in FIG. 2 according to an embodiment of the present invention,
FIG. 4 illustrates a control scheme involved with the method shown in FIG. 2 according to another embodiment of the present invention,
FIG. 5 illustrates a series of impedance profiles involved with the method shown in FIG. 2 according to an embodiment of the present invention,
FIG. 6 is a diagram of an apparatus for performing impedance profile control of a PDN in an electronic device according to another embodiment of the present invention, where this apparatus comprises an integrated circuit (IC), and
FIG. 7 is a diagram of an apparatus for performing impedance profile control of a PDN in an electronic device according to another embodiment of the present invention, where this apparatus comprises an IC.

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

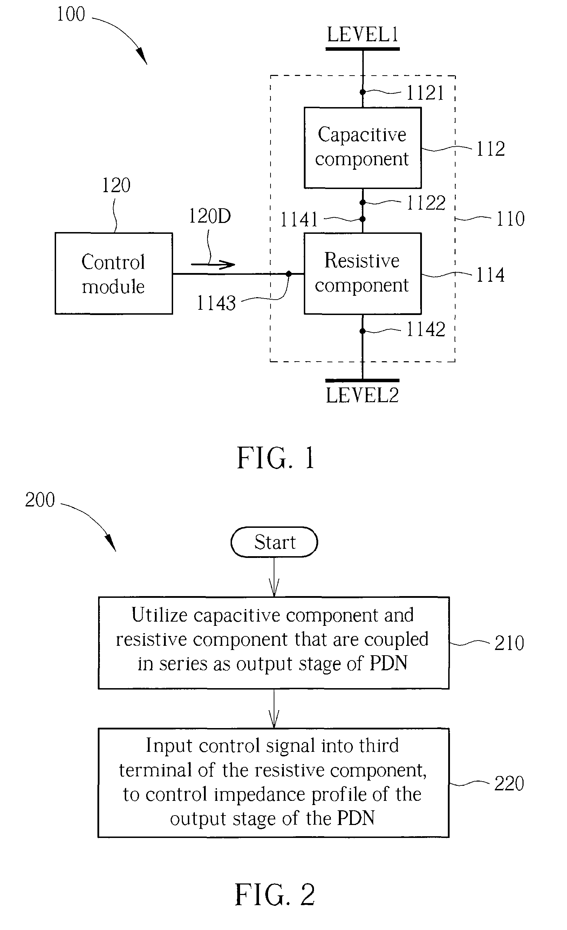

FIG. 1 illustrates a diagram of an apparatus 100 for performing impedance profile control of a power delivery network (PDN) in an electronic device according to a first embodiment of the present invention, where the apparatus 100 comprises at least one portion (e.g. a portion or all) of the electronic device. As shown in FIG. 1, the apparatus 100 may comprise a capacitive component 112 such as at least one component (e.g. one or more components) equipped with characteristic(s) of a capacitor, and a resistive component 114 such as at least one component (e.g. one or more components) equipped with characteristic(s) of a variable resistor, and may further comprise a control module 120. According to this embodiment, the capacitive component 112 and the resistive component 114 are coupled in series, and the control module 120 is coupled to the resistive component 114. For example, the capacitive component 112 may comprise one terminal 1121 coupled to a first voltage level LEVEL1 of the PDN and may further comprise another terminal 1122, and the resistive component 114 may comprise a first terminal 1141 coupled to the other terminal 1122 of the capacitive component 112 and comprise a second terminal 1142 coupled to a second voltage level LEVEL2 of the PDN, and may further comprise a third terminal 1143. In addition, the control module 120 may be arranged for inputting a control signal into the third terminal 1143 of the resistive component 114, to control an impedance profile of the output stage 110 of the PDN. For example, this control signal may be a digital control signal 120D. This is for illustrative purposes only, and is not meant to be a limitation of the present invention. According to some embodiments of the present invention, this control signal may be an analog control signal. For example, the digital control signal 120D input into the third terminal 1143 of the resistive component 114 shown in FIG. 1 may be replaced by the analog control signal in these embodiments.

According to some embodiments, the capacitive component 112 can be a two terminal component, and the resistive component 114 can be a three terminal component. This is for illustrative purposes only, and is not meant to be a limitation of the present invention. According to some embodiments of the present invention, it is unnecessary that the capacitive component is a two terminal component and that the resistive component is a three terminal component.

FIG. 2 illustrates a flowchart of a method 200 for performing impedance profile control of a PDN in an electronic device according to an embodiment of the present invention. The method 200 shown in FIG. 2 can be applied to the apparatus 100 shown in FIG. 1. The method can be described as follows.

In Step 210, the apparatus 100 may utilize the capacitive component 112 and the resistive component 114 that are coupled in series as an output stage 110 of the PDN, where one terminal 1121 of the capacitive component 112 is coupled to the first voltage level LEVEL1 of the PDN, and the first terminal 1141 and the second terminal 1142 of the resistive component 114 are coupled to the other terminal 1121 of the capacitive component 112 and the second voltage level LEVEL2 of the PDN, respectively.

In Step 220, the control module 120 may input the aforementioned control signal (e.g. the digital control signal 120D, or the analog control signal mentioned in some embodiments described between the embodiments respectively shown in FIG. 1 and FIG. 2) into the third terminal 1143 of the resistive component 114, to control the impedance profile of the output stage 110 of the PDN, where in at least one predetermined state of the control signal, the control signal is a time variant signal. For example, the control signal may be the digital control signal 120D, wherein in a logical state of the digital control signal 120D, the digital control signal 120D is the aforementioned time variant signal. More particularly, this logical state of the digital control signal 120D may repeatedly enable and disable the signal path between the first terminal 1141 and the second terminal 1142 of the resistive component 114, and may alternatively turn on or off this signal path.

As a result of utilizing the digital control signal 120D to control the resistive component 114, the control module 120 may control the equivalent impedance of the resistive component 114 in response to the variation of the digital control signal 120D, where the quality (Q) factor of the output stage 110 may be reduced correspondingly. This is for illustrative purposes only, and is not meant to be a limitation of the present invention. Please note that, when needed, the control module 120 may completely disable the signal path between the first terminal 1141 and the second terminal 1142 of the resistive component 114. For example, in another logical state of the digital control signal 120D, the digital control signal 120D can be a turn off signal. More particularly, the other logical state of the digital control signal 120D may completely disable the signal path between the first terminal 1141 and the second terminal 1142 of the resistive component 114.

According to this embodiment, one of the first voltage level LEVEL1 and the second voltage level LEVEL2 can be coupled to a power source of the PDN, and another of the first voltage level LEVEL1 and the second voltage level LEVEL2 can be coupled to a ground terminal of the PDN. This is for illustrative purposes only, and is not meant to be a limitation of the present invention. According to some embodiments of the present invention, the first voltage level LEVEL1 can be a first supply voltage of the PDN (e.g. the first voltage level LEVEL1 can be coupled to the aforementioned power source of the PDN), and the second voltage level LEVEL2 can be a second supply voltage of the PDN (e.g. the second voltage level LEVEL2 can be coupled to another power source of the PDN).

According to some embodiments, in Step 220, the apparatus 100 (e.g. the control module 120) may generate a voltage variant signal. In addition, the voltage of the voltage variant signal may change with respect to time. Additionally, the apparatus 100 may utilize the voltage variant signal as the digital control signal 120D in the logical state of the digital control signal 120D.

According to some embodiments, in Step 220, the apparatus 100 (e.g. the control module 120) may generate a mono-tone signal. In addition, the mono-tone signal may correspond to a predetermined frequency. Additionally, the apparatus 100 may utilize the mono-tone signal as the digital control signal 120D in the logical state of the digital control signal 120D.

According to some embodiments, in Step 220, the apparatus 100 (e.g. the control module 120) may generate a random data signal. In addition, the random data signal may correspond to a predetermined data density. Additionally, the apparatus 100 may utilize the random data signal as the digital control signal 120D in the logical state of the digital control signal 120D.

According to some embodiments, in Step 220, the apparatus 100 (e.g. the control module 120) may generate a modulation signal. In addition, the modulation signal may carry a predetermined modulation pattern. Additionally, the apparatus 100 may utilize the random data signal as the digital control signal 120D in the logical state of the digital control signal 120D.

According to some embodiments, the control module 120 may comprise a time variant signal source that is coupled to the third terminal 1143 of the resistive component 114. In addition, the time variant signal source is arranged for generating the control signal mentioned in Step 220 (e.g. the digital control signal 120D, or the analog control signal mentioned in some embodiments described between the embodiments respectively shown in FIG. 1 and FIG. 2).

According to some embodiments, the control module 120 may change at least one characteristic (e.g. one or more characteristics) of the digital control signal 120D to adjust the frequency response of the output stage 110 of the PDN in the logical state of the digital control signal 120D. In addition, the aforementioned at least one characteristic may cause the variation of the digital control signal 120D to be changed.

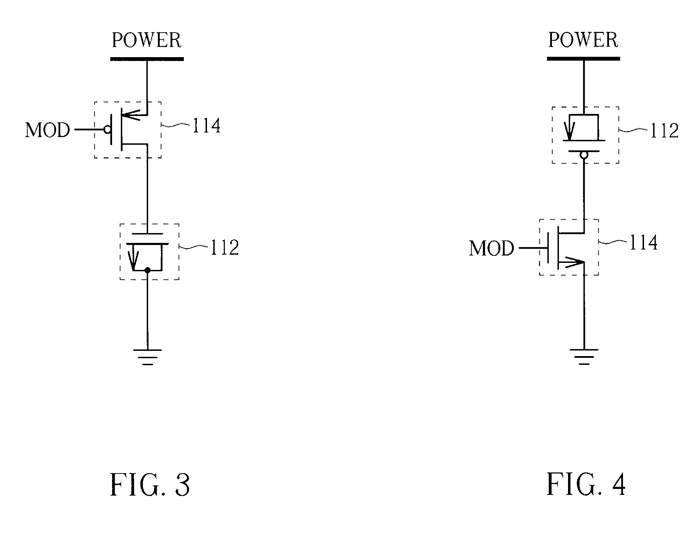

FIG. 3 illustrates a control scheme involved with the method 200 shown in FIG. 2 according to an embodiment of the present invention. As shown in FIG. 3, some Metal Oxide Semiconductor Field Effect Transistors (MOSFETs) can be utilized for implementing the capacitive component 112 and the resistive component 114. For example, the capacitive component 112 of this embodiment may comprise an N-type MOSFET (NMOSFET), and the resistive component 114 of this embodiment may comprise a P-type MOSFET (PMOSFET). In addition, a modulation signal MOD such as the voltage variant signal mentioned above can be taken as an example of the control signal mentioned in Step 220 (e.g. the digital control signal 120D, or the analog control signal mentioned in some embodiments described between the embodiments respectively shown in FIG. 1 and FIG. 2), and can be input into the gate terminal of this PMOSFET. Additionally, the second voltage level LEVEL2 can be coupled to the aforementioned power source of the PDN, and therefore can be illustrated with the associated supply voltage POWER of the PDN. Further, the first voltage level LEVEL1 can be coupled to the aforementioned ground terminal of the PDN, and therefore can be illustrated with the ground notation shown in the bottommost of FIG. 3. For brevity, similar descriptions for this embodiment are not repeated in detail here.

FIG. 4 illustrates a control scheme involved with the method 200 shown in FIG. 2 according to another embodiment of the present invention. As shown in FIG. 4, some MOSFETs can be utilized for implementing the capacitive component 112 and the resistive component 114. For example, the capacitive component 112 of this embodiment may comprise a PMOSFET, and the resistive component 114 of this embodiment may comprise an NMOSFET. In addition, the modulation signal MOD such as the voltage variant signal mentioned above can be taken as an example of the control signal mentioned in Step 220 (e.g. the digital control signal 120D, or the analog control signal mentioned in some embodiments described between the embodiments respectively shown in FIG. 1 and FIG. 2), and can be input into the gate terminal of this NMOSFET. Additionally, the first voltage level LEVEL1 can be coupled to the aforementioned power source of the PDN, and therefore can be illustrated with the associated supply voltage POWER of the PDN. Further, the second voltage level LEVEL2 can be coupled to the aforementioned ground terminal of the PDN, and therefore can be illustrated with the ground notation shown in the bottommost of FIG. 4. For brevity, similar descriptions for this embodiment are not repeated in detail here.

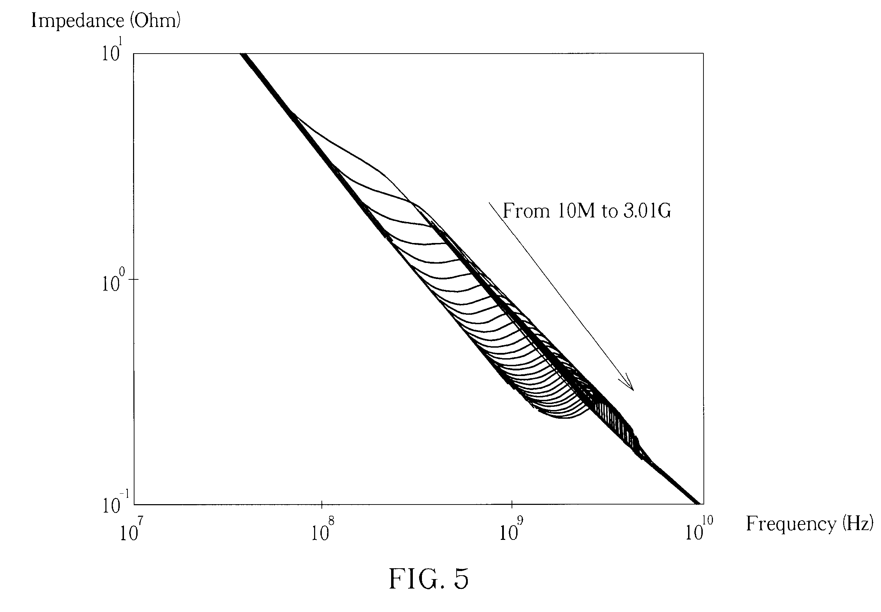

FIG. 5 illustrates a series of impedance profiles involved with the method 200 shown in FIG. 2 according to an embodiment of the present invention. The horizontal axis shown in FIG. 5 may represent frequency measured in unit of Hertz (Hz), and the vertical axis shown in FIG. 5 may represent impedance measured in unit of Ohm. In addition, the modulation signal MOD such as the voltage variant signal mentioned above can be taken as an example of the control signal mentioned in Step 220 (e.g. the digital control signal 120D, or the analog control signal mentioned in some embodiments described between the embodiments respectively shown in FIG. 1 and FIG. 2), and can be input into the third terminal 1143 of the resistive component 114 (e.g. the gate terminal of the PMOSFET shown in FIG. 3, or the gate terminal of the NMOSFET shown in FIG. 4).

According to this embodiment, the series of impedance profiles shown in FIG. 5 can be taken as an example of a plurality of impedance profiles between the terminal 1121 of the capacitive component 112 and the second terminal 1142 of the resistive component 114 in different conditions, respectively, and more particularly, may represent the frequency response of the output stage 110 (e.g. Impedance vs. Frequency) in these conditions, respectively, where a plurality of predetermined values of the frequency of the modulation signal MOD can be taken as an example of these conditions. For example, the modulation signal MOD can be the mono-tone signal mentioned above. As the frequency of the mono-tone signal may vary (e.g. from 10 Mega-Hurtz (MHz) to 3.01 Giga-Hurtz (GHz), labeled "From 10M to 3.01G" in FIG. 5, for better comprehension), the associated impedance profile of the output stage 110 of the PDN may vary.

As shown in FIG. 5, each of most of the curves (e.g. the curves of the series of impedance profiles shown in FIG. 5, except for the upper three curves) may have a local minimum and a local maximum, and the two sides of any of the curves shown in FIG. 5 may overlap the two sides of another of these curves. The uppermost curve (i.e. the curve of the first one of the series of impedance profiles shown in FIG. 5) may correspond to the frequency of 10 MHz, and the bottommost curve (i.e. the curve of the last one of the series of impedance profiles shown in FIG. 5) may correspond to the frequency of 3.01 GHz. Please note that, as the frequency of the modulation signal MOD increases, the local minimum of the associated curve moves toward the lower right. Therefore, by utilizing the digital control signal 120D such as the modulation signal MOD of this embodiment to control the resistive component 114, the control module 120 may control the equivalent impedance of the resistive component 114 (e.g. measured in unit of Ohm, as shown in FIG. 5) in response to the variation of the digital control signal 120D, and therefore may control the Q factor of the output stage 110 correspondingly. For brevity, similar descriptions for this embodiment are not repeated in detail here.

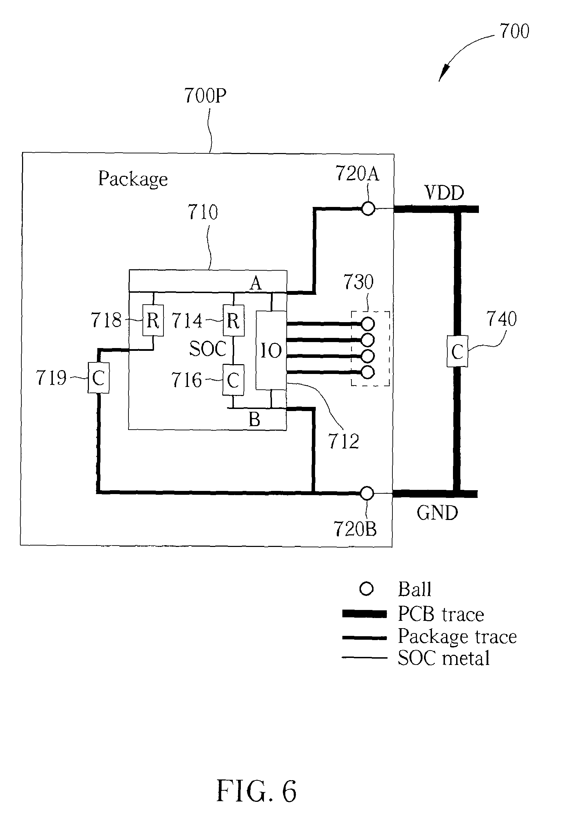

FIG. 6 is a diagram of an apparatus 700 for performing impedance profile control of a PDN in an electronic device according to another embodiment of the present invention, where this apparatus 700 may comprise an integrated circuit (IC) 710. According to this embodiment, the IC 710 may comprise an input/output (I/O) module 712 (labeled "IO" in FIG. 6, for brevity), and may further comprise a resistor 714 (labeled "R" in FIG. 6, for brevity) and a capacitor 716 (labeled "C" in FIG. 6, for brevity), which can be taken as examples of the resistive component 114 and the capacitive component 112, respectively. In addition, another resistor 718 (labeled "R" in FIG. 6, for brevity) of the IC 710 and a capacitor 719 (labeled "C" in FIG. 6, for brevity) positioned outside the IC 710 can also be taken as examples of the resistive component 114 and the capacitive component 112, respectively. Additionally, the I/O module 712 may comprise a memory control circuit having a set of memory I/O terminals (e.g. a control circuit of various types of double data rate (DDR) Synchronous Dynamic Random Access Memory (SDRAM), such as that of DDR2 SDRAM, DDR3 SDRAM, etc.). This is for illustrative purposes only, and is not meant to be a limitation of the present invention. In some examples, the set of memory I/O terminals can be replaced by another type of I/O terminals, where the I/O module 712 may comprise another type of circuits.

For example, the IC 710 can be a semiconductor chip within a system on chip (SOC, or SoC) architecture, and therefore the IC 710 can be labeled "SOC" and the internal electrical connections of the IC 710 (e.g. two conductive wires that are arranged for respectively conducting a predetermined voltage level A and another predetermined voltage level B in this embodiment, and the electrical connections between some of the I/O module 712, the resistor 714, the capacitor 716, and the two conductive wires) can be illustrated with SOC metal, for better comprehension. This is for illustrative purposes only, and is not meant to be a limitation of the present invention. In some examples, IC 710 can be a chip within one of another type of architectures. As shown in FIG. 6, the apparatus 700 may comprise a package 700P for packaging the IC 710 together with the capacitor 719, where the package 700P may comprise a plurality of terminals 720A, 720B, and 730 coupled to the IC 710. More particularly, the terminals 730 can be coupled to the corresponding I/O terminals of the IC 710. For better comprehension, a package implemented with the Ball Grid Array (BGA) technologies can be taken as an example of the package 700P, and therefore the terminals 720A, 720B, and 730 can be illustrated with balls and the electrical connections between the IC 710 and the terminals 720A, 720B, and 730 can be illustrated with package trace, for example. This is for illustrative purposes only, and is not meant to be a limitation of the present invention. In some examples, the package 700P can be implemented with another type of technologies, such as Quad Flat Package (QFP) technologies, Dual In-line Package (DIP) technologies, Pin Grid Array (PGA) technologies, etc.

In practice, the package 700P can be installed on a printed circuit board (PCB) of the electronic device mentioned above. For example, the PCB may comprise a plurality of PCB traces, where a PCB trace within the plurality of PCB traces may be arranged to conduct a predetermined voltage level VDD to the terminal 720A of the package 700P, and another PCB trace within the plurality of PCB traces may be arranged to conduct a ground voltage level GND to the terminal 720B of the package 700P. As a result, the predetermined voltage level A of this embodiment can be equivalent to the predetermined voltage level VDD, and the other predetermined voltage level B of this embodiment can be equivalent to the ground voltage level GND. In addition, the PCB may further comprise a capacitor 740 (labeled "C" in FIG. 6, for brevity) that are coupled between the predetermined voltage level VDD and the ground voltage level GND of this embodiment. This is for illustrative purposes only, and is not meant to be a limitation of the present invention. According to some embodiments of the present invention, it is unnecessary to implement the capacitor 740. For brevity, similar descriptions for this embodiment are not repeated in detail here.

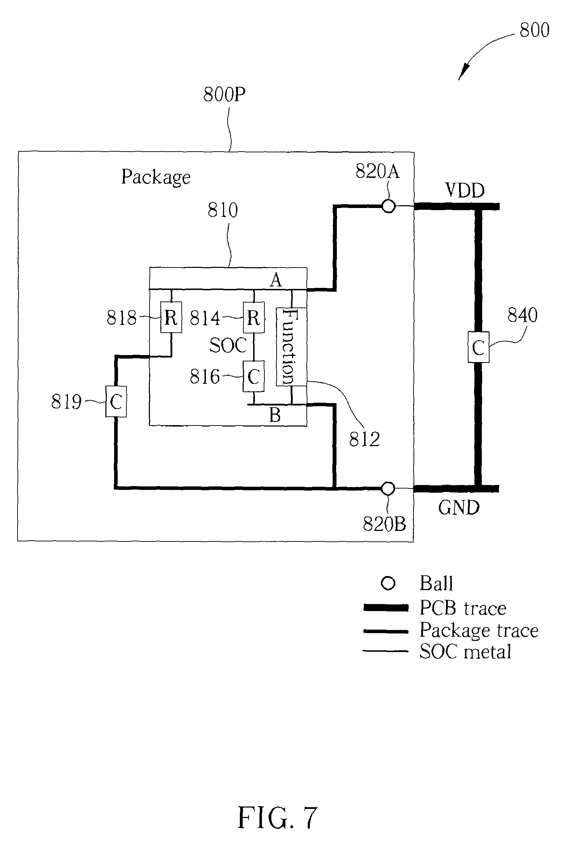

FIG. 7 is a diagram of an apparatus 800 for performing impedance profile control of a PDN in an electronic device according to another embodiment of the present invention, where this apparatus 800 may comprise an IC 810. According to this embodiment, the IC 810 may comprise a function module 812 (labeled "Function" in FIG. 7, for brevity), and may further comprise a resistor 814 (labeled "R" in FIG. 7, for brevity) and a capacitor 816 (labeled "C" in FIG. 7, for brevity), which can be taken as examples of the resistive component 114 and the capacitive component 112, respectively. In addition, another resistor 818 (labeled "R" in FIG. 7, for brevity) of the IC 810 and a capacitor 819 (labeled "C" in FIG. 7, for brevity) positioned outside the IC 810 can also be taken as examples of the resistive component 114 and the capacitive component 112, respectively. Additionally, the function module 812 may comprise at least one core circuit (e.g. one or more core circuits) of a processor, such as a core of a central processing unit (CPU). This is for illustrative purposes only, and is not meant to be a limitation of the present invention. In some examples, the function module 812 may comprise another type of circuits.

For example, the IC 810 can be a semiconductor chip within a SOC (or SoC) architecture, and therefore the IC 810 can be labeled "SOC" and the internal electrical connections of the IC 810 (e.g. the aforementioned two conductive wires that are arranged for respectively conducting the predetermined voltage level A and the other predetermined voltage level B in this embodiment, and the electrical connections between some of the function module 812, the resistor 814, the capacitor 816, and the two conductive wires) can be illustrated with SOC metal, for better comprehension. This is for illustrative purposes only, and is not meant to be a limitation of the present invention. In some examples, IC 810 can be a chip within one of another type of architectures. As shown in FIG. 7, the apparatus 800 may comprise a package 800P for packaging the IC 810 together with the capacitor 819, where the package 800P may comprise a plurality of terminals 820A and 820B coupled to the IC 810. For better comprehension, a package implemented with the BGA technologies can be taken as an example of the package 800P, and therefore the terminals 820A and 820B can be illustrated with balls and the electrical connections between the IC 810 and the terminals 820A and 820B can be illustrated with package trace, for example. This is for illustrative purposes only, and is not meant to be a limitation of the present invention. In some examples, the package 800P can be implemented with another type of technologies, such as QFP technologies, DIP technologies, PGA technologies, etc.

In practice, the package 800P can be installed on a PCB of the electronic device mentioned above. For example, the PCB may comprise a plurality of PCB traces, where a PCB trace within the plurality of PCB traces may be arranged to conduct a predetermined voltage level VDD such as that mentioned above to the terminal 820A of the package 800P, and another PCB trace within the plurality of PCB traces may be arranged to conduct a ground voltage level GND such as that mentioned above to the terminal 820B of the package 800P. As a result, the predetermined voltage level A of this embodiment can be equivalent to the predetermined voltage level VDD, and the other predetermined voltage level B of this embodiment can be equivalent to the ground voltage level GND. In addition, the PCB may further comprise a capacitor 840 (labeled "C" in FIG. 7, for brevity) that are coupled between the predetermined voltage level VDD and the ground voltage level GND of this embodiment. This is for illustrative purposes only, and is not meant to be a limitation of the present invention. According to some embodiments of the present invention, it is unnecessary to implement the capacitor 840. For brevity, similar descriptions for this embodiment are not repeated in detail here.

All combinations and sub-combinations of above-described features also belong to the invention.

## Claims

1. A method for performing impedance profile control of a power delivery network (PDN) in an electronic device (100, 700, 800), **characterized in that** the method comprises the steps o£
utilizing a capacitive component (112, 716, 719, 816, 819) and a resistive component (114, 714, 718, 814, 818) that are coupled in series as an output stage (110) of the PDN, wherein the capacitive component comprises one terminal (1121) coupled to a first voltage level of the PDN and further comprises another terminal (1122), and the resistive component comprises a first terminal (1141) coupled to the other terminal (1122) of the capacitive component and further comprises a second terminal (1142) coupled to a second voltage level of the PDN; and
inputting a control signal into a third terminal (1143) of the resistive component, to control an impedance profile of the output stage of the PDN, wherein in at least one predetermined state of the control signal, the control signal is a time variant signal.

2. The method of claim 1, **characterized in that** the capacitive component (112, 716, 719, 816, 819) is a two terminal component, and the resistive component is a three terminal component.

3. The method of claim 1, **characterized in that** the first voltage level is a first supply voltage of the PDN, and the second voltage level is a second supply voltage of the PDN.

4. The method of claim 1, **characterized in that** one of the first voltage level and the second voltage level is coupled to a power source of the PDN, and another of the first voltage level and the second voltage level is coupled to a ground terminal of the PDN.

5. The method of claim 1, **characterized in that** the control signal is a digital control signal, wherein in a logical state of the digital control signal, the digital control signal is the time variant signal; and the method further comprises:
generating a voltage variant signal, wherein a voltage of the voltage variant signal changes with respect to time; and
utilizing the voltage variant signal as the digital control signal in the logical state of the digital control signal.

6. The method of claim 1, **characterized in that** the control signal is a digital control signal, wherein in a logical state of the digital control signal, the digital control signal is the time variant signal; and the method further comprises:
generating a mono-tone signal, wherein the mono-tone signal corresponds to a predetermined frequency; and
utilizing the mono-tone signal as the digital control signal in the logical state of the digital control signal.

7. The method of claim 1, **characterized in that** the control signal is a digital control signal, wherein in a logical state of the digital control signal, the digital control signal is the time variant signal; and the method further comprises:
generating a random data signal, wherein the random data signal corresponds to a predetermined data density; and
utilizing the random data signal as the digital control signal in the logical state of the digital control signal.

8. The method of claim 1, **characterized in that** the control signal is a digital control signal, wherein in a logical state of the digital control signal, the digital control signal is the time variant signal; and the method further comprises:
generating a modulation signal, wherein the modulation signal carries a predetermined modulation pattern; and
utilizing the random data signal as the digital control signal in the logical state of the digital control signal.

9. The method of claim 1, **characterized in that** the method further comprises:
utilizing a time variant signal source to generate the control signal.

10. The method of claim 1, **characterized in that** the control signal is a digital control signal, wherein in a logical state of the digital control signal, the digital control signal is the time variant signal; and the method further comprises:
changing at least one characteristic of the digital control signal to adjust the frequency response of the output stage (110) in the logical state of the digital control signal, wherein the at least one characteristic causes variation of the digital control signal to be changed.

11. An apparatus (100, 700, 800) for performing impedance profile control of a power delivery network (PDN) in an electronic device (100, 700, 800), the apparatus comprising at least one portion of an electronic device, **characterized in that** the apparatus comprises:
a capacitive component (112, 716, 719, 816, 819) and a resistive component (114, 714, 718, 814, 818) that are coupled in series, utilized as an output stage (110) of the PDN, wherein the capacitive component comprises one terminal (1121) coupled to a first voltage level of the PDN and further comprises another terminal (1122), and the resistive component comprises a first terminal (1141) coupled to the other terminal (1122) of the capacitive component and further comprises a second terminal (1142) coupled to a second voltage level of the PDN; and
a control module (120), coupled to the resistive component, arranged for inputting a control signal into a third terminal (1143) of the resistive component, to control an impedance profile of the output stage of the PDN, wherein in at least one predetermined state of the control signal, the control signal is a time variant signal.

12. The apparatus of claim 11, **characterized in that** the capacitive component (112, 716, 719, 816, 819) is a two terminal component, and the resistive component is a three terminal component.

13. The apparatus of claim 11, **characterized in that** the first voltage level is a first supply voltage of the PDN, and the second voltage level is a second supply voltage of the PDN.

14. The apparatus of claim 11, **characterized in that** one of the first voltage level and the second voltage level is coupled to a power source of the PDN, and another of the first voltage level and the second voltage level is coupled to a ground terminal of the PDN.

15. The apparatus of claim 11, **characterized in that** the control signal is a digital control signal, wherein in a logical state of the digital control signal, the digital control signal is the time variant signal; and the control module changes at least one characteristic of the digital control signal to adjust the frequency response of the output stage (110) in the logical state of the digital control signal, wherein the at least one characteristic causes variation of the digital control signal to be changed.
